# FASCICULE DE BREVET EUROPEEN

(11) **EP 3 155 660 B1**
(45) Date de publication et mention de la délivrance du brevet: **09.01.2019**
(21) Numéro de dépôt: 15732562.2
(22) Date de dépôt: 12.06.2015
(51) Int. Cl.: H01L 27/144, H01L 27/146

(54) **CAPTEUR MATRICIEL BISPECTRAL ET SON PROCÉDÉ DE FABRICATION**
BISPEKTRALER MATRIXSENSOR UND VERFAHREN ZUR HERSTELLUNG DAVON
BISPECTRAL MATRIX SENSOR AND METHOD FOR MANUFACTURING SAME

(30) Priorité: 13.06.2014 FR 1455449
(43) Date de publication de la demande: 19.04.2017
(73) Titulaire: Safran Electronics & Defense, 92100 Boulogne-Billancourt (FR)
(72) Inventeur: SIK, Hervé, 92100 Boulogne-Billancourt (FR); FLEURY, Joël, 92100 Boulogne-Billancourt (FR); LAPRAT, Patrice, 92100 Boulogne-Billancourt (FR)
(74) Mandataire: Regimbeau
(86) Numéro de dépôt international: PCT/EP2015/063244
(87) Numéro de publication internationale: WO 2015/189423

(56) Documents cités:
- EP-A1- 0 650 199
- US-A1- 2009 225 204
- US-A1- 2011 013 055
- John Wallace: "IR IMAGING: Imager combines SWIR and MWIR sensitivity", Laser Focus World Laser Focus World, vol. 49, no. 02 13 février 2013 (2013-02-13), XP002743427, Extrait de l'Internet: URL:http://www.laserfocusworld.com/article s/print/volume-49/issue-02/world-news/ir-i maging--imager-combines-swir-and-mwir-sens itivity.html [extrait le 2015-08-18]

## Description

### DOMAINE DE L'INVENTION

La présente invention concerne le domaine des capteurs matriciels bi-spectraux et leurs procédés de fabrication.

### ETAT DE LA TECHNIQUE

Une combustion dans l'atmosphère se traduit par un spectre présentant un certain nombre de caractéristiques distinctives et notamment des pics entre d'une part 1,9 et 2 micromètres et d'autre part entre 3,5 et 4,2 micromètres et entre 4,55 et 4,8 micromètres.

Cette propriété est avantageusement utilisée pour détecter les tirs d'arme à feu, qui produisent des émissions dont le ratio entre les intensités dans les deux bandes spectrales est caractéristique. Pour ce faire, il est nécessaire de pouvoir détecter en temps réel les rayonnements dans ces deux bandes spectrales de façon simultanée et avec une très bonne résolution spatiale et une très grande sensibilité.

On peut certes utiliser deux voies spectrales partiellement ou complètement différentes mais de tels systèmes sont chers et encombrants. De plus, la performance des systèmes fonctionnant sur ce principe repose en grande partie sur la stabilité, en fonction des différentes conditions opérationnelles, des niveaux de signal dans les bandes spectrales considérées et de leurs rapports respectifs. On se doit donc d'utiliser des systèmes offrant très peu de différences entre les voies spectrales et donc rechercher un maximum d'éléments communs. Le document US2011/0013055 décrit un détecteur bispectral dans les bandes du visible et d'infrarouge.

John Wallace décrit dans l'article "IR IMAGING: Imager combines SWIR and MWIR sensitivity" (Laser Focus World, vol.49 no.2, 13 février 2013) un détecteur infrarouge bispectral.

Il a donc été proposé d'utiliser un capteur matriciel monotype devant lequel est placé une matrice de filtres constituée d'un damier de filtres de deux types différents laissant respectivement passer les rayonnements dans une première bande de fréquences et dans une seconde bande de fréquences. La matrice de filtres affecte la moitié des photosites à la détection dans une première bande de fréquences et l'autre moitié des photosites à la détection dans une seconde bande de fréquences, permettant ainsi de détecter les rayonnements dans deux bandes de fréquences différentes sur un seul capteur matriciel monotype.

A cet effet, il a été proposé d'utiliser une matrice de filtres interférentiels. Un filtre interférentiel est un filtre obtenu par dépôt de minces couches de divers matériaux sur un substrat. Ces couches produisent des interférences constructives dans certaines longueurs d'ondes et des interférences destructives dans certaines autres longueurs d'ondes. Selon la complexité du filtre, il sera possible de laisser passer ou de couper une ou plusieurs bandes spectrales.

Or, il est impossible de créer, par dépôt de couches minces, une matrice de filtres respectivement passant dans une première bande de fréquence et dans une seconde bande de fréquence à la dimension du pixel. En effet, les empilements de couches minces constituant une telle matrice de filtre présentent des épaisseurs de l'ordre de grandeur de la dimension du photosite du détecteur matriciel. Une matrice de filtre ainsi fabriquée présenterait des surfaces de diffraction importantes qui dégraderaient considérablement le contraste et la résolution optique du détecteur.

Pour contourner le problème, il a notamment été proposé, de réaliser des détecteurs avec empilements de multicouches absorbantes par épitaxie moléculaire ou en phase gazeuse. L'inconvénient des technologies d'épitaxie est qu'elles sont coûteuses.

Il a également été proposé de réaliser des filtres sur substrat reporté sur la surface sensible du détecteur. Ces filtres présentent de nombreux inconvénients. La distance entre le filtre et la surface active génère un phénomène de diffraction qui a pour conséquence une perte de résolution optique et un faible coefficient de remplissage.

### EXPOSE DE L'INVENTION

L'invention permet de pallier au moins à un des inconvénients précités en proposant un procédé de fabrication d'un détecteur bispectral par dépôt de couches minces.

A cet effet, l'invention propose un procédé de fabrication d'un détecteur matriciel bispectral comme décrit dans la revendication 1.

L'invention présente des avantages multiples.

La superposition d'un filtre bi-bande et d'une matrice de filtres respectivement passe-bas et passe-haut, étant équivalente à une matrice de filtres bi-bande, l'invention permet de réaliser un détecteur matriciel bispectral par dépôt de couches minces.

L'invention permet en outre de minimiser la perte de coefficient de remplissage ('fill factor') tout en maximisant la résolution optique du détecteur.

L'invention autorise la réalisation de filtres aux dimensions des photosites des détecteurs matriciels au plan focal (ou FPA pour 'Focal Plane Array'), c'est-à-dire de l'ordre de 10µm.

L'invention présente l'avantage d'être compacte par rapport à un filtre reporté sur la surface sensible du détecteur, puisque dans l'invention la matrice de filtres est directement déposée sur la surface sensible du détecteur.

L'invention est avantageusement complétée par les caractéristiques suivantes, prises individuellement ou en l'une quelconque de leurs combinaisons techniquement possibles :
- le premier filtre interférentiel et le second filtre interférentiel sont déposés sur le filtre interférentiel bi-bande ;
- le premier filtre interférentiel et le second filtre interférentiel sont déposés directement sur le filtre interférentiel bi-bande (par directement on entend qu'il n'y a pas de couche intermédiaire entre le premier filtre interférentiel et le filtre interférentiel bi-bande ou entre le second filtre interférentiel et le filtre interférentiel bi-bande) ;
- le dépôt du premier filtre interférentiel à l'aplomb des photosites destinés à capter dans la première bande de fréquences comporte les étapes suivantes ;
   - dépôt du premier filtre interférentiel sur l'ensemble de la surface sensible du détecteur matriciel monotype;
   - dépôt d'une couche protectrice sur les parties du premier filtre interférentiel à l'aplomb des photosites destinés à capter dans la première bande de fréquences ;
   - gravure des parties du premier filtre interférentiel non protégées par la couche protectrice ;
- la couche protectrice est déposée par photolithographie ;
- le procédé de fabrication comporte en outre une étape préalable au dépôt du premier filtre interférentiel, et consistant à déposer une couche tampon ;
- le procédé de fabrication comporte en outre une étape préalable au dépôt du premier filtre interférentiel, et consistant à déposer une couche d'arrêt ;
- le dépôt du second filtre interférentiel à l'aplomb des photosites destinés à capter dans la seconde bande de fréquences, comporte des étapes de :
   - dépôt d'une couche sacrificielle à l'aplomb des photosites destinés à capter dans la première bande de fréquences ;
   - dépôt du second filtre interférentiel sur l'ensemble de la surface sensible;
   - élimination de la couche sacrificielle ;
- l'élimination de la couche sacrificielle est réalisée par lavage chimique ;
- l'élimination de la couche sacrificielle est réalisée par contrainte mécanique ;
- le dépôt des filtres interférentiels consiste à déposer une superposition de couches de ZnS, SiO₂ et Ge.
- un premier filtre interférentiel déposé sur le filtre interférentiel bi-bande à l'aplomb des photosites destinés à capter dans la première bande de fréquences
- un second filtre interférentiel déposé sur le filtre interférentiel bi-bande à l'aplomb des photosites destinés à capter dans la seconde bande de fréquences ;
un des filtres interférentiels parmi le premier et le second filtre interférentiel étant un filtre passe-bas coupant la seconde bande de fréquences du filtre bi-bande et l'autre un filtre passe-haut coupant la première bande de fréquences du filtre bi-bande.

L'invention concerne également un détecteur matriciel bispectral comme décrit dans la revendication 9.

### DESCRIPTION DES FIGURES

D'autres objectifs, caractéristiques et avantages sortiront de la description détaillée qui suit en référence aux dessins donnés à titre illustratif et non limitatif parmi lesquels :
- la figure 1 représente un détecteur matriciel bispectral conforme à l'invention ;
- la figure 2 représente la surface sensible d'un détecteur matriciel monotype ;

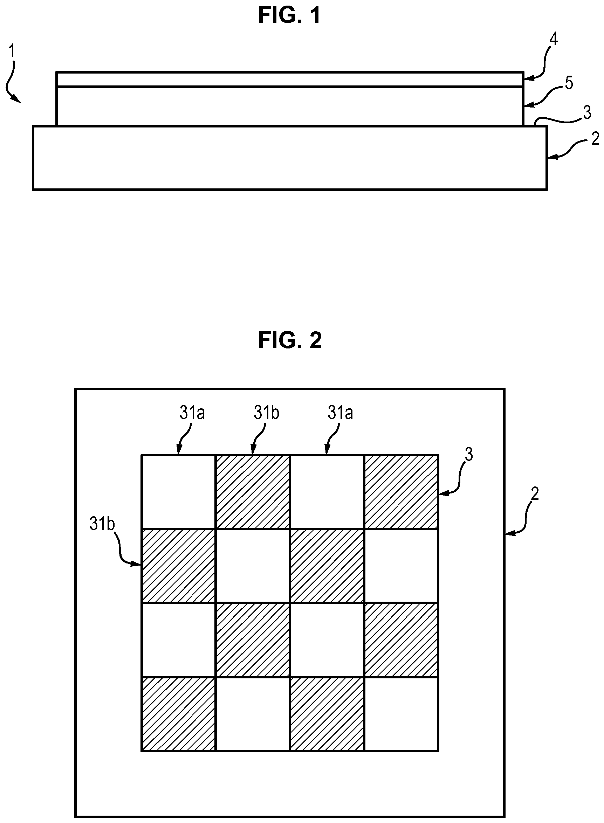

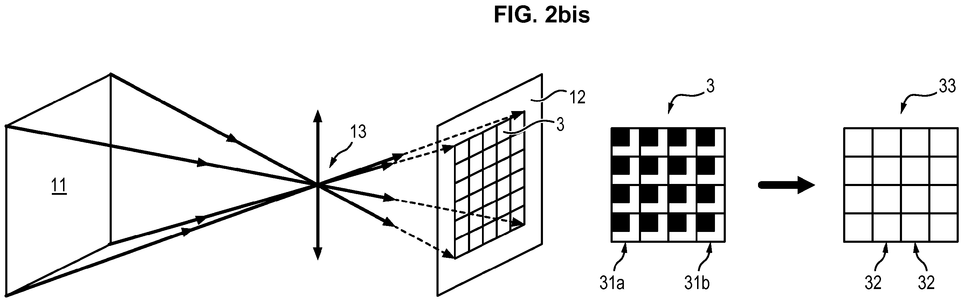

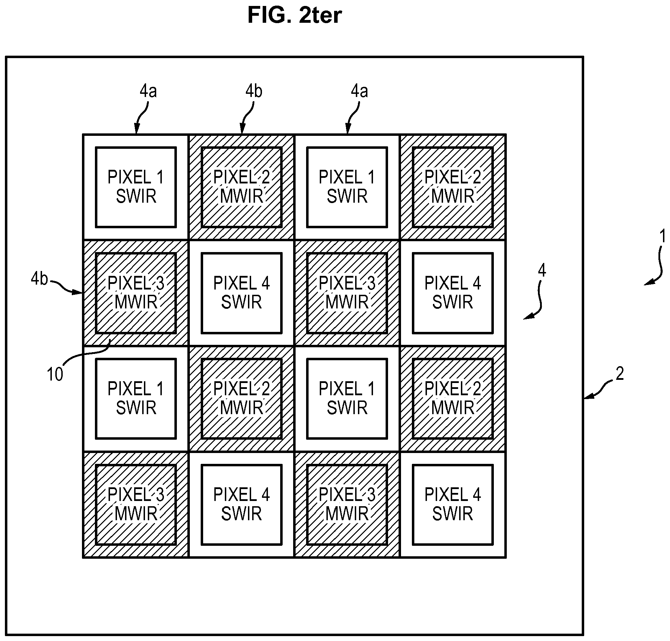

- la figure 2bis représente un détecteur matriciel monotype conforme à l'invention ;
- la figure 2ter représente une matrice de filtres bispectrale conforme à l'invention ;

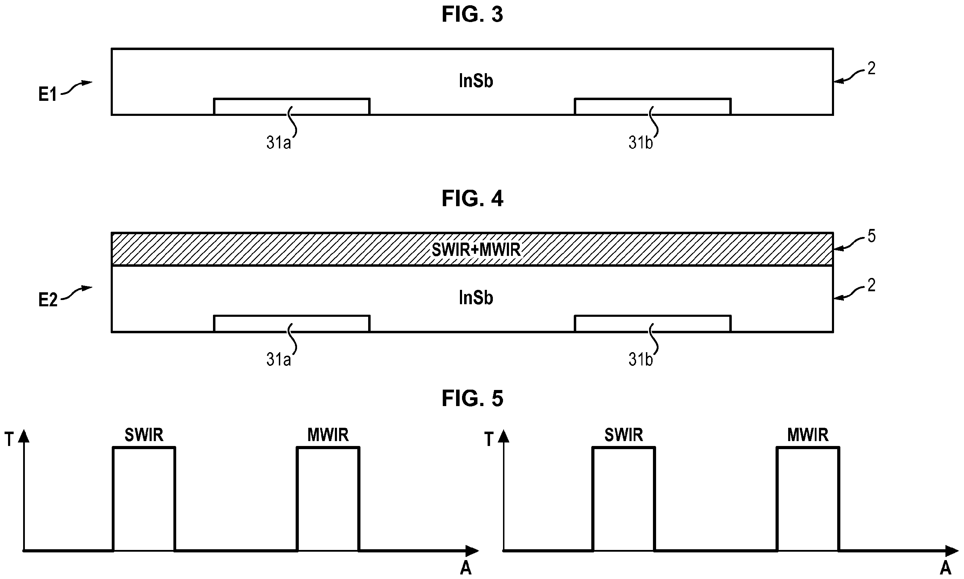

- la figure 3 représente une étape de fourniture d'une surface sensible d'un détecteur;
- la figure 4 représente une étape de dépôt d'un filtre interférentiel bi-bande;
- la figure 5 représente le profil de transmittance du filtre interférentiel bi-bande ;

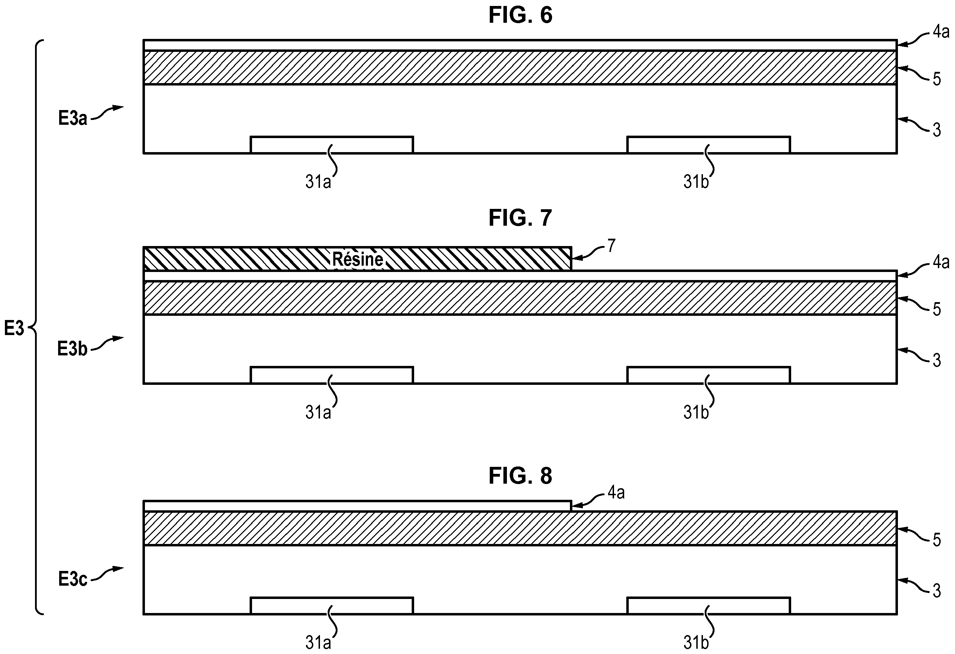

- la figure 6 représente une étape de dépôt d'un premier filtre interférentiel;
- la figure 7 représente une étape de dépôt d'une couche protectrice sur la partie de la surface à l'aplomb des photosites destinés à capter dans une première bande de fréquences ;
- la figure 8 représente une étape de retrait des parties du premier filtre interférentiel non protégées par la couche protectrice;

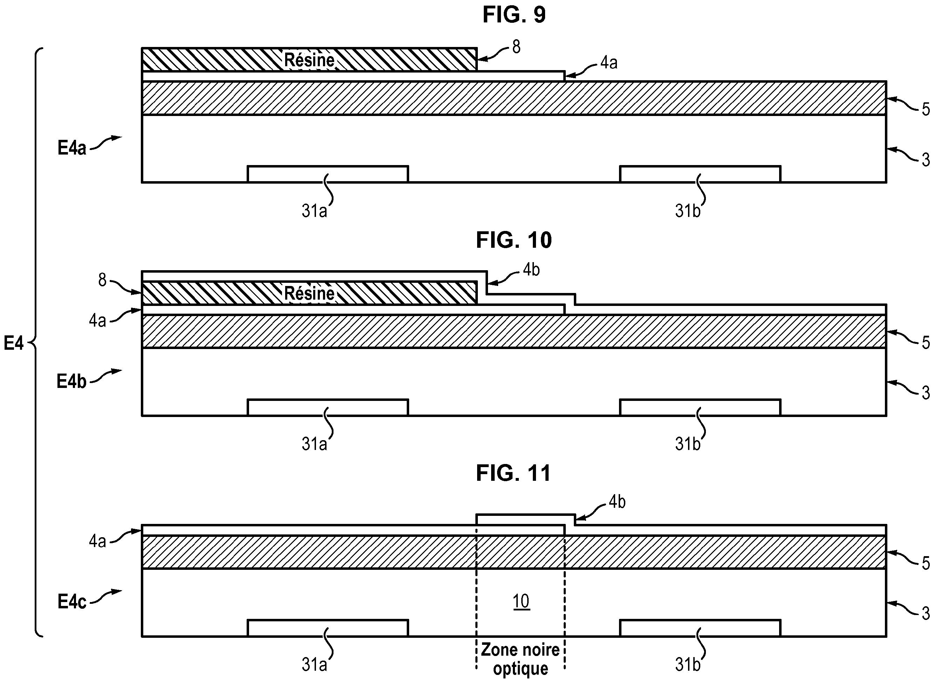

- la figure 9 représente une étape de dépôt d'une couche sacrificielle sur la partie de la surface à l'aplomb des photosites destinés à capter dans une seconde bande de fréquences ;
- la figure 10 représente une étape de dépôt d'un second filtre ;
- la figure 11 représente une étape d'élimination de la couche sacrificielle ;

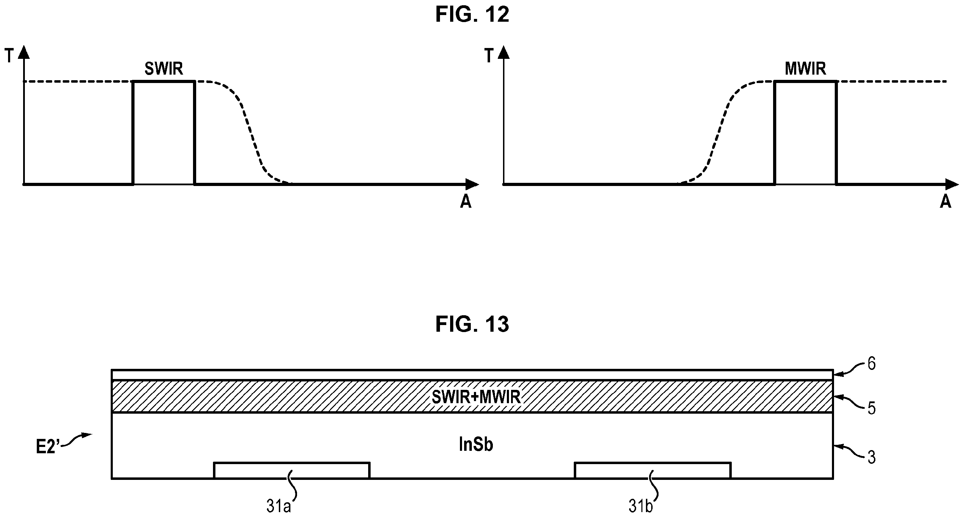

- sur la figure 12 est représenté à gauche le profil de transmittance du filtre interférentiel bi-bande superposé au premier filtre, et à droite le profil de transmittance du filtre interférentiel bi-bande superposé au second filtre ;
- la figure 13 représente une étape de dépôt d'une couche d'arrêt;

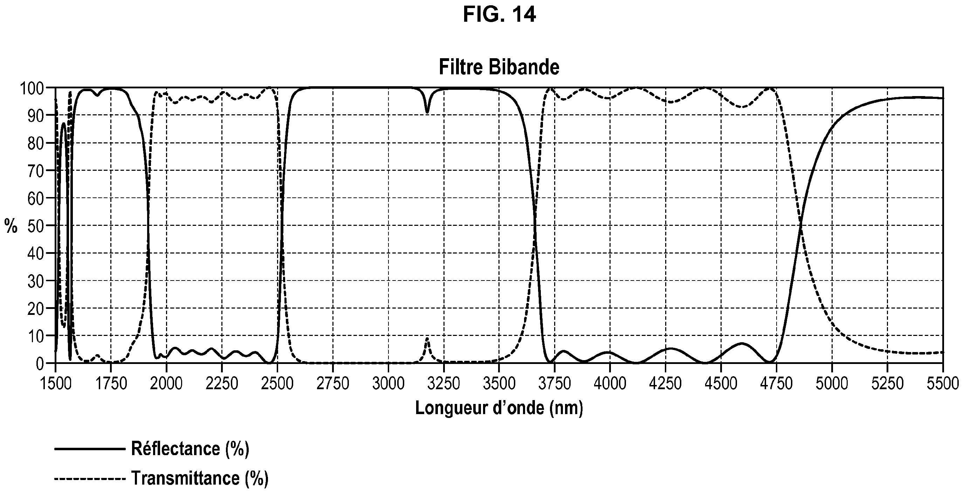

- la figure 14 représente la transmittance et réflectance d'un exemple de filtre bi-bande ;

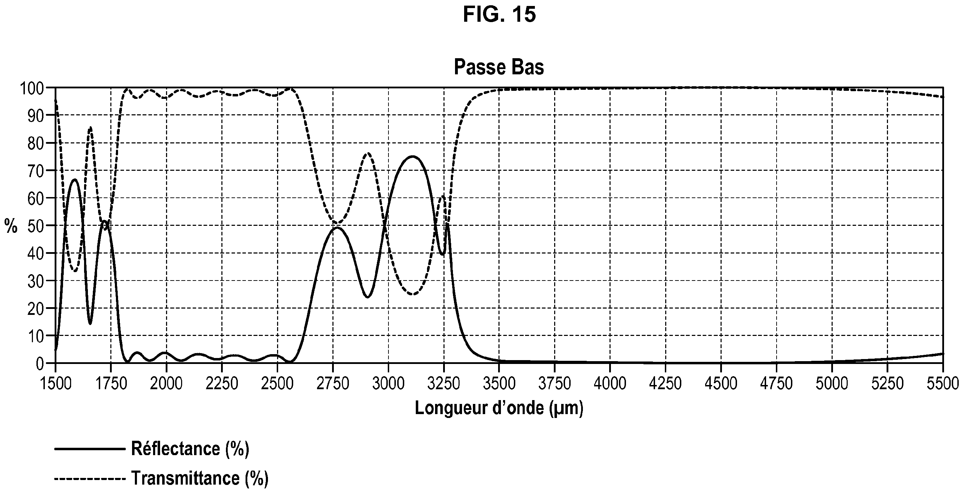

- la figure 15 représente la transmittance et réflectance d'un exemple de filtre passe-bas ;

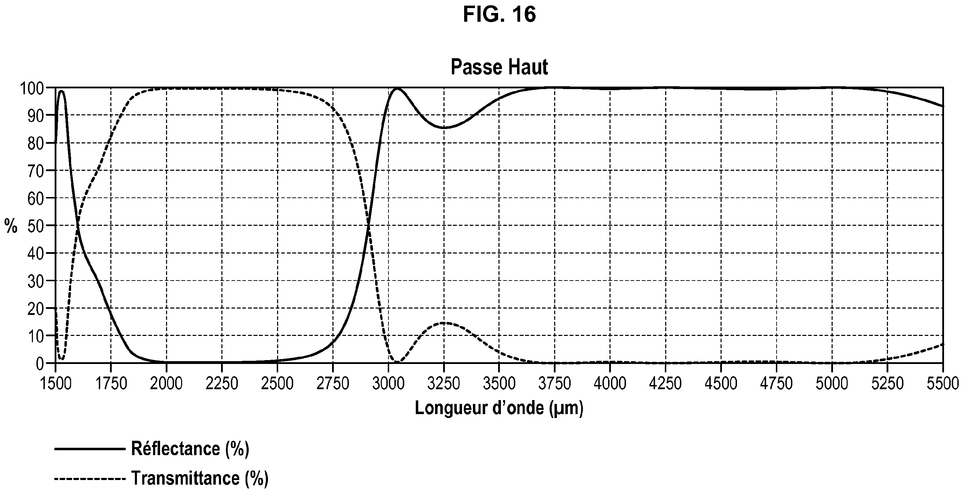

- la figure 16 représente la transmittance et réflectance d'un exemple de filtre passe-haut.

### DESCRIPTION DETAILLEE DE L'INVENTION

En référence à la figure 1, un détecteur matriciel bispectral 1 comprend un détecteur matriciel monotype 2 comportant une surface sensible 3 ou 'matrice' sur laquelle ont été successivement déposés un filtre bi-bande 5 et une matrice de filtres 4 constituée d'une alternance de filtres passe-haut et passe bas.

En référence à la figure 2, la surface sensible 3 du détecteur matriciel monotype 2 est composée d'un alignement de photosites 31a et 31b disposés en rangées et colonnes.

En référence à la figure 2bis, le détecteur matriciel monotype 2 est typiquement un détecteur matriciel au plan focal (ou FPA pour 'Focal Plane Array'), c'est-à-dire que sa surface sensible 3 est composée de suffisamment de photosites 31a et 31b pour éviter les balayages mécaniques ou optiques pour une résolution spatiale désirée. Une image 33 de la scène 11 se forme dans le plan focal 12 de l'objectif 13 focalisé à l'infini. La surface sensible 3 est placée dans le plan focal 12, d'où le nom de la matrice FPA. Le détecteur matriciel monotype 2 fonctionne typiquement dans l'infrarouge et image donc une scène thermique 11.

Un photosite 31a et 31b est un composant élémentaire de la surface d'un capteur d'image, qui capte la luminosité d'un pixel 32 de l'image 33. Il y a un et un seul photosite pour chaque pixel 32 de l'image. Les colonnes et rangées de ces photosites 31a et 31b composent la surface sensible 3 du détecteur matriciel monotype 2. Chaque photosite 31a et 31b comporte un photodétecteur. Les photodétecteurs fonctionnent par absorption de photons infrarouge et photogénération de porteurs de charge (effet photovoltaïque ou photoconducteur) créant un excès de courant dans le matériau (photocourant). Les photodétecteurs sont par exemple des photodiodes PN (principalement en tellurure de mercure-cadmium - HgCdTe), ou des photodiodes PIN à hétérojonction de type II, (en antimoniure d'indium (InSb)). Le rapport entre la surface totale du photosite 31a et 31b et la surface du photodétecteur est appelé taux de remplissage (fill factor en anglais).

Le détecteur matriciel monotype 2 est monotype au sens que l'ensemble de ses photosites 31a et 31b sont sensibles à la même gamme de longueurs d'onde.

Bien que tous les photosites 31a et 31b sont sensibles à la même gamme de longueurs d'onde, une partie d'entre eux est affectée à la détection dans une première bande de fréquences et l'autre partie est affectée à la détection dans une seconde bande de fréquences, de manière à ce que le détecteur matriciel 1 détecte les rayonnements dans ces deux bandes de fréquences. La gamme de longueurs d'onde à laquelle sont sensibles les photosites 31a et 31b comprend la première et la seconde bande de fréquences. En référence à la figure 2, la surface sensible 3 est composée d'une alternance (ou damier) de photosites 31a destinés à capter dans une première bande de fréquences et de photosites 31b destinés à capter dans une seconde bande de fréquences.

Dans l'exemple de réalisation décrit, la première bande de fréquences correspond aux rayonnements ayant une longueur d'onde comprise entre 3 et 6 micromètres correspondant à la bande de longueurs d'onde dite 'infrarouge moyen' ou 'medium wavelength infrared' (MWIR) tandis que la seconde bande de fréquences correspond aux rayonnements ayant une longueur d'onde comprise entre 0.75 et 3 micromètres correspondant à la bande de longueurs d'onde dite 'proche infrarouge' ou 'short wavelength infrared' (SWIR).

En référence à la figure 5, le filtre bi-bande 5 laisse passer les rayonnements dans la première et la seconde bande de fréquences uniquement, le filtre bi-bande 5 est donc un filtre SWIR+MWIR.

En référence à la figure 2ter, la matrice de filtres 4 est une juxtaposition de filtres interférentiels 4a et 4b respectivement passe-bas et passe-haut.

Le procédé de fabrication d'un détecteur matriciel bispectral 1 comporte les étapes suivantes ;
- E1 fourniture d'un détecteur matriciel monotype 2 comportant une surface sensible 3 composée d'une alternance de photosites 31a destinés à capter dans une première bande de fréquences et de photosites 31b destinés à capter dans une seconde bande de fréquences (voir figure 3),
- E2 dépôt d'un filtre interférentiel bi-bande 5 laissant passer les rayonnements dans la première et la seconde bande de fréquences sur la surface sensible 3 (voir figure 4) ;
- E3 dépôt d'un premier filtre interférentiel 4a à l'aplomb des photosites 31a destinés à capter dans la première bande de fréquences (voir figure 6, 7 et 8);
- E4 dépôt d'un second filtre interférentiel 4b à l'aplomb des photosites 31a destinés à capter dans la seconde bande de fréquences (voir figure 9, 10 et 11).

Le premier filtre interférentiel 4a et le second filtre interférentiel 4b sont déposés sur le filtre interférentiel bi-bande 5, respectivement à l'aplomb des photosites 31a destinés à capter dans la première bande de fréquences et à l'aplomb des photosites 31a destinés à capter dans la seconde bande de fréquences.

Le premier filtre interférentiel 4a et le second filtre interférentiel 4b peuvent notamment être déposés directement sur le filtre interférentiel bi-bande 5 (par directement on entend qu'il n'y a pas de couche intermédiaire entre le premier filtre interférentiel et le filtre interférentiel bi-bande ou entre le second filtre interférentiel et le filtre interférentiel bi-bande

Le premier filtre interférentiel 4a et le second filtre interférentiel 4b peuvent également être déposés sur une couche d'arrêt 6 déposée sur le filtre interférentiel bi-bande 5.

Un des filtres interférentiels 4a, 4b parmi le premier 4a et le second 4b filtre interférentiel est un filtre passe-bas et l'autre un filtre passe-haut. Dans l'exemple de réalisation décrit ci-dessous, le premier filtre interférentiel 4a est passe-bas et le second 4b passe-haut, mais il est bien entendu possible que le premier filtre interférentiel 4a soit passe-haut et le second 4b passe-bas.

Les filtres interférentiels 4a, 4b et 5 sont réalisés par empilements de couches de matériaux d'indices de réfraction différents. Ces couches produisent des interférences constructives dans certaines longueurs d'ondes et des interférences destructives dans certaines autres longueurs d'ondes, de manière à ce que seuls les rayonnements aux longueurs d'onde choisies soient transmis, les autres rayonnements étant réfléchis. Selon la complexité du filtre, il sera possible de laisser passer ou de couper une ou plusieurs bandes spectrales. Les filtres interférentiels 4a, 4b et 5 sont typiquement composés d'une superposition d'alternance de couches de ZnS, SiO₂ et Ge. Le dépôt de cette succession de couches est typiquement effectué par évaporation ou par pulvérisation cathodique.

Le dépôt E3 du premier filtre interférentiel 4a à l'aplomb des photosites 31a destinés à capter dans la première bande de fréquences comporte les étapes suivantes ;
- E3a dépôt du premier filtre interférentiel 4a sur l'ensemble de la surface sensible 3 du détecteur matriciel monotype 2 (voir la figure 6);
- E3b dépôt d'une couche protectrice 7 sur les parties du premier filtre interférentiel 4a à l'aplomb des photosites 31a destinés à capter dans la première bande de fréquences (voir la figure 7) ;
- E3c gravure des régions du premier filtre interférentiel 4a non protégées par la couche protectrice 7 (voir la figure 8).

La couche protectrice 7 est par exemple une résine photosensible déposée en utilisant des techniques de photolithographie. Les étapes du procédé de photolithographie, commencent par l'application de la couche protectrice 7 sous forme d'un film fin sur l'ensemble de la surface du premier filtre 4a. Celle-ci est ensuite exposée à une irradiation. Lors de cette étape l'utilisation d'un masque, formé de zones opaques et transparentes, permet de définir le motif que l'on souhaite reproduire sur la couche protectrice 7. L'exposition crée des réactions au sein de la résine et engendre des modifications chimiques, les zones irradiées vont voir leur solubilité évoluer suivant le type de résine - positive ou négative. Les solvants spécifiques contenus dans le développeur vont permettre d'éliminer la résine exposée ou non selon sa solubilité.

La résine photosensible composant la couche protectrice 7 doit d'une part être sensible à l'irradiation, afin d'assurer la reproduction fidèle et précise de l'image du masque, et d'autre part protéger efficacement le substrat durant la gravure, ce qui implique une certaine résistance aux agents utilisés pour la gravure ainsi qu'une épaisseur suffisante. On utilise typiquement une couche protectrice 7 de 3 micromètres d'épaisseur constituée d'une résine positive.

La gravure E3c peut être une gravure ionique, gravure plasma, et/ou une gravure chimique. Dans le cas d'une gravure ionique, la résine suffisamment épaisse bloquera, là où elle est présente, l'implantation d'ions dans le substrat. L'étape de gravure E3c élimine le premier filtre 4a dans toutes les régions non recouvertes par la couche protectrice 7, les motifs de la couche protectrice 7 seront alors reproduits sur le premier filtre 4a.

Dans le cas où la gravure est une gravure chimique ou plasma, et en référence à la figure 13, le procédé de fabrication comporte une étape E2' préalable au dépôt du premier filtre 4a, et consistant à déposer une couche d'arrêt 6. La couche d'arrêt 6 est réalisée dans un matériau optiquement neutre, c'est-à-dire ayant un indice de réfraction proche de 1 typiquement compris entre 1 et 1.5 et résistant à la gravure de l'étape E3c, comme par exemple du SiO₂ ou du MgF2. Dans le cas d'un matériau tel que le YF₃ son indice plus élevé impose le dépôt d'une couche plus fine.

Dans le cas où la gravure est une gravure par gravure ionique, et en référence à la figure 14, le procédé de fabrication peut en outre comporte une étape E2' préalable au dépôt du premier filtre 4a, et consistant à déposer une couche d'arrêt 6. La couche d'arrêt 6 est destinée à assurer l'intégrité du filtre large bande lors de la gravure de l'étape E3c. La couche d'arrêt 6 est typiquement en SiO2 ou MgF2. L'épaisseur de la couche d'arrêt 6 est choisie de manière à ce que la gravure ionique ne vienne pas attaquer le filtre large bande 5. On utilise par exemple une couche d'arrêt 6 de 0.25 micromètre d'épaisseur en SiO2. Dans le cas d'une couche d'arrêt en oxyde d'yttrium(III) (Y2O3), l'épaisseur serait de l'ordre de 0.12 micromètre

A la fin de la gravure de l'étape E3c, la résine est retirée en utilisant un solvant comme par exemple de l'acétone.

Le dépôt E4 du second filtre interférentiel 4b à l'aplomb des photosites 31b destinés à capter dans la seconde bande de fréquences, comportant des étapes de :
- E4a dépôt d'une couche sacrificielle 8 à l'aplomb des photosites 31a destinés à capter dans la première bande de fréquences (voir figure 9);
- E4b dépôt du second filtre interférentiel 4b sur l'ensemble de la surface sensible 3 (voir figure 10);
- E4c élimination de la couche sacrificielle 8 (voir figure 11).

Diverses méthodes peuvent être utilisées pour déposer la couche sacrificielle 8, notamment la lithographie par ultraviolet ou la lithographie par faisceau d'électrons. A cet effet, la couche sacrificielle 8 est déposée sur l'ensemble de la surface du substrat, puis gravée en motif inverse (en l'occurrence gravure de la couche sacrificielle à l'aplomb des photosites 31b destinés à capter dans la seconde bande de fréquences).

En référence à la figure 10, lors de l'étape E4b, le second filtre 4b est ensuite déposé sur tout le substrat (en l'occurrence le filtre bi-bande 5) dans les régions gravées et sur la couche sacrificielle 8 dans les régions où elle n'a pas été préalablement gravée.

En référence à la figure 11, l'étape E4c d'élimination de la couche sacrificielle 8 est typiquement réalisée par lavage (résine photosensible dans un solvant), irradiation, par contrainte mécanique ou par vibrations. La matière déposée sur la couche sacrificielle 8 est éliminée avec la couche sacrificielle 8, tandis que la matière déposée directement sur le substrat n'est pas éliminée. Le second filtre 4b demeure par conséquent uniquement dans les régions où il était en contact direct avec le substrat (en l'occurrence le filtre bi-bande 5).

En référence à la figure 12, le filtre passe-bas 4a coupe la seconde bande de fréquences du filtre bi-bande 5, tandis que le filtre passe haut 4b coupe la première bande de fréquences du filtre bi-bande 5. La superposition du filtre bi-bande 5 et du filtre passe-bas 4a est donc équivalente à un filtre passe-bande laissant passer la première bande de fréquences, tandis que la superposition du filtre bi-bande 5 et du filtre passe-haut 4b est équivalente à un filtre passe-bande laissant passer la seconde bande de fréquences. Par conséquent, la superposition d'un filtre bi-bande 5 sur l'ensemble de la surface sensible 3 et de la matrice de filtres respectivement passe-bas 4a et passe-haut 4b, est équivalente à une matrice de filtre respectivement passant dans une première bande de fréquences et dans une seconde bande de fréquences.

Sur la figure 14, on a représenté la transmittance et la réflectance d'un exemple de filtre bi-bande SWIR+MWIR 5 constitué d'une trentaine de couches, le filtre bi-bande SWIR+MWIR 5 ayant une épaisseur totale d'environ 10 micromètres. Comme illustré par la figure 14, la réalisation d'un filtre très sélectif, (et notamment un filtre bi-bande à bande de transmission étroite comme le filtre bi-bande SWIR+MWIR 5) nécessite la superposition d'un nombre important de couches. Un filtre très sélectif est donc par conséquent nécessairement épais, ce qui a pour conséquence de rendre impossible la réalisation, par dépôt de couches minces, d'une matrice de filtres respectivement passant dans une première bande de fréquences et dans une seconde bande de fréquences à la dimension du pixel.

Sur la figure 15, on a représenté la transmittance et réflectance d'un exemple de filtre passe-bas constitué d'une douzaine de couches dont l'épaisseur totale est de 4 micromètres environ. Sur la figure 16, on a représenté la transmittance et réflectance d'un exemple de filtre passe-haut constitué d'une douzaine de couches dont l'épaisseur totale est de 5 micromètres environ. Comme illustré par les figures 15 et 16, la réalisation d'un filtre peu sélectif (et notamment un filtre passe-haut 4b ou passe-bas 4a) nécessite la superposition d'un nombre moins important de couches. Il est par conséquent possible de réaliser, par dépôt de couches minces, une matrice de filtres respectivement passe-bas et passe-haut à des ordres de grandeur très faible et notamment à la dimension du pixel.

En référence à la figure 11, la zone de chevauchement 10 entre les deux filtres 4a et 4b correspond à la zone entre les photosites 31a et 31b. Cette zone de chevauchement 10 est absorbante et peut être soit réduite (typiquement jusqu'à 1µm) de manière maximiser le taux de remplissage des photosites ('fill factor'), soit amplifiée (typiquement jusqu'à 10 µm) pour minimiser le couplage parasite entre les photosites ('cross-talk').

## Revendications

1. Procédé de fabrication d'un détecteur matriciel bispectral (1) dans l'infrarouge comportant les étapes suivantes :
- (E1) fourniture d'un détecteur matriciel monotype (2) comportant une surface sensible (3) composée d'une alternance de photosites (31a) destinés à capter dans une première bande de fréquences et de photosites (31b) destinés à capter dans une seconde bande de fréquences, ledit détecteur matriciel étant monotype en ce que lesdits photosites sont sensibles à une même gamme de longueurs d'onde comprenant la première bande de fréquences et la seconde bande de fréquences;
- (E2) dépôt, sur la surface sensible (3), d'un filtre interférentiel bi-bande (5) laissant passer les rayonnements dans la première et la seconde bande de fréquences ;
- (E3) dépôt d'un premier filtre interférentiel (4a) à l'aplomb des photosites (31a) destinés à capter dans la première bande de fréquences ;
- (E4) dépôt d'un second filtre interférentiel (4b) à l'aplomb des photosites (31b) destinés à capter dans la seconde bande de fréquences,
un des filtres interférentiels (4a, 4b) parmi le premier (4a) et le second (4b) filtre interférentiel étant un filtre passe-bas coupant la seconde bande de fréquences, et l'autre un filtre passe-haut coupant la première bande de fréquences, le premier filtre interférentiel (4a) et le second filtre interférentiel (4b) étant déposés sur le filtre interférentiel bi-bande (5).

2. Procédé de fabrication d'un détecteur matriciel bispectral (1) selon la revendication 1, l'étape de (E3) dépôt d'un premier filtre interférentiel (4a) comportant une étape de gravure, le procédé de fabrication comportant en outre une étape (E2') préalable au dépôt du premier filtre (4a), et consistant à déposer une couche d'arrêt (6), l'épaisseur et le matériau de la couche d'arrêt (6) étant choisi de manière à ce que la gravure n'attaque pas le filtre interférentiel bi-bande (5).

3. Procédé de fabrication d'un détecteur matriciel bispectral (1) selon l'une des revendications précédentes, le dépôt (E3) du premier filtre interférentiel (4a) à l'aplomb des photosites (31a) destinés à capter dans la première bande de fréquences comportant les étapes suivantes ;
- (E3a) dépôt du premier filtre interférentiel (4a) sur l'ensemble de la surface sensible (3) du détecteur matriciel monotype (2) ;
- (E3b) dépôt d'une couche protectrice (7) sur les parties du premier filtre interférentiel (4a) à l'aplomb des photosites (31a) destinés à capter dans la première bande de fréquences ;
- (E3c) gravure des parties du premier filtre interférentiel (4a) non protégées par la couche protectrice (7).

4. Procédé de fabrication d'un détecteur matriciel bispectrale (1) selon la revendication précédente, la couche protectrice (7) est déposée par photolithographie.

5. Procédé de fabrication d'un détecteur matriciel bispectral (1) selon l'une des revendications précédentes, le dépôt (E4) du second filtre interférentiel (4b) à l'aplomb des photosites (31b) destinés à capter dans la seconde bande de fréquences, comportant des étapes de :
- (E4a) dépôt d'une couche sacrificielle (8) à l'aplomb des photosites (31a) destinés à capter dans la première bande de fréquences ;
- (E4b) dépôt du second filtre interférentiel (4b) sur l'ensemble de la surface sensible (3) ;
- (E4c) élimination de la couche sacrificielle (8).

6. Procédé de fabrication d'un détecteur matriciel bispectral (1) selon la revendication précédente, l'élimination (E9) de la couche sacrificielle étant réalisée par lavage chimique.

7. Procédé de fabrication d'un détecteur matriciel bispectral (1) selon la revendication 5, l'élimination (E9) de la couche sacrificielle étant réalisée par contrainte mécanique.

8. Procédé de fabrication d'un détecteur matriciel bispectral (1) selon l'une des revendications précédentes, le dépôt des filtres interférentiels (4a, 4b, 5) consistant à déposer une superposition de couches de ZnS, SiO₂ et Ge.

9. Détecteur matriciel bispectral (1) dans l'infrarouge comportant :
- une surface sensible (3) composée d'une alternance de photosites (31a) destinés à capter dans une première bande de fréquences et de photosites (31b) destinés à capter dans une seconde bande de fréquences, ledit détecteur matriciel étant monotype en ce que lesdits photosites sont sensibles à une même gamme de longueurs d'onde comprenant la première bande de fréquences et la seconde bande de fréquences;
- un filtre interférentiel bi-bande (5) laissant passer les rayonnements dans la première et la seconde bande de fréquences déposé sur la surface sensible (3);
- un premier filtre interférentiel (4a) déposé sur le filtre interférentiel bi-bande (5) à l'aplomb des photosites (31a) destinés à capter dans la première bande de fréquences,
- un second filtre interférentiel (4b) déposé sur le filtre interférentiel bi-bande (5) à l'aplomb des photosites (31b) destinés à capter dans la seconde bande de fréquences ;
un des filtres interférentiels (4a, 4b) parmi le premier (4a) et le second (4b) filtre interférentiel étant un filtre passe-bas coupant la seconde bande de fréquences, et l'autre un filtre passe-haut coupant la première bande de fréquences, et le premier filtre interférentiel (4a) et le second filtre interférentiel (4b) étant déposés sur le filtre interférentiel bi-bande (5).

## Patentansprüche

1. Verfahren zur Herstellung eines im Infrarot bispektralen Matrixdetektors (1), das die folgenden Schritte aufweist:
- (E1) Bereitstellen eines Monotyp-Matrixdetektors (2), aufweisend eine sensible Oberfläche (3), zusammengesetzt aus einer Abfolge von Photostellen (31a), die bestimmt sind, in einem ersten Frequenzband zu empfangen, und von Photostellen (31b), die bestimmt sind, in einem zweiten Frequenzband zu empfangen, wobei der Matrixdetektor monotyp dahingehend ist, dass die Photostellen für einen selben Wellenlängenbereich sensibel sind, umfassend das erste Frequenzband und das zweite Frequenzband;
- (E2) Aufbringen, auf die sensible Oberfläche (3), eines Doppelband-Interferenzfilters (5), welcher die Strahlungen im ersten und zweiten Frequenzband passieren lässt;
- (E3) Aufbringen eines ersten Interferenzfilters (4a) senkrecht zu den Photostellen (31a), die bestimmt sind, im ersten Frequenzband zu empfangen;
- (E4) Aufbringen eines zweiten Interferenzfilters (4b) senkrecht zu den Photostellen (31b), die bestimmt sind, im zweiten Frequenzband zu empfangen,
wobei einer der Interferenzfilter (4a, 4b) von dem ersten (4a) und dem zweiten (4b) Interferenzfilter ein Tiefpassfilter ist, welcher das zweite Frequenzband abschneidet, und der andere ein Hochpassfilter, welcher das erste Frequenzband abschneidet, wobei der erste Interferenzfilter (4a) und der zweite Interferenzfilter (4b) auf dem Doppelband-Interferenzfilter (5) aufgebracht sind.

2. Verfahren zur Herstellung eines bispektralen Matrixdetektors (1) nach Anspruch 1, wobei der Schritt des Aufbringens (E3) eines ersten Interferenzfilters (4a) einen Gravurschritt aufweist, wobei das Herstellungsverfahren ferner einen Schritt (E2') vor dem Aufbringen des ersten Filters (4a) aufweist und darin besteht, eine Sperrschicht (6) aufzubringen, wobei die Stärke und das Material der Sperrschicht (6) derart ausgewählt sind, dass die Gravur den Doppelband-Interferenzfilter (5) nicht angreift.

3. Verfahren zur Herstellung eines bispektralen Matrixdetektors (1) nach einem der vorangehenden Ansprüche, wobei das Aufbringen (E3) des ersten Interferenzfilters (4a) senkrecht zu den Photostellen (31a), die bestimmt sind, im ersten Frequenzband zu empfangen, die folgenden Schritte aufweist:
- (E3a) Aufbringen des ersten Interferenzfilters (4a) auf die gesamte sensible Oberfläche (3) des Monotyp-Matrixdetektors (2);
- (E3b) Aufbringen einer Schutzschicht (7) auf die Teile des ersten Interferenzfilters (4a) senkrecht zu den Photostellen (31a), die bestimmt sind, im ersten Frequenzband zu empfangen;
- (E3c) Gravieren der nicht von der Schutzschicht (7) geschützten Teile des ersten Interferenzfilters (4a).

4. Verfahren zur Herstellung eines bispektralen Matrixdetektors (1) nach vorangehendem Anspruch, wobei die Schutzschicht (7) durch Photolithographie aufgebracht wird.

5. Verfahren zur Herstellung eines bispektralen Matrixdetektors (1) nach einem der vorangehenden Ansprüche, wobei das Aufbringen (E4) des zweiten Interferenzfilters (4b) senkrecht zu den Photostellen (31b), die bestimmt sind, im zweiten Frequenzband zu empfangen, die folgenden Schritte aufweist:
- (E4a) Aufbringen einer Opferschicht (8) senkrecht zu den Photostellen (31a), die bestimmt sind, im ersten Frequenzband zu empfangen;
- (E4b) Aufbringen des zweiten Interferenzfilters (4b) auf die gesamte sensible Oberfläche (3);
- (E4c) Entfernen der Opferschicht (8).

6. Verfahren zur Herstellung eines bispektralen Matrixdetektors (1) nach vorangehendem Anspruch, wobei das Entfernen (E9) der Opferschicht durch chemisches Waschen durchgeführt wird.

7. Verfahren zur Herstellung eines bispektralen Matrixdetektors (1) nach Anspruch 5, wobei das Entfernen (E9) der Opferschicht durch mechanische Beanspruchung durchgeführt wird.

8. Verfahren zur Herstellung eines bispektralen Matrixdetektors (1) nach einem der vorangehenden Ansprüche, wobei das Aufbringen der Interferenzfilter (4a, 4b, 5) darin besteht, eine Übereinanderfolge von Schichten von ZnS, SiO₂ und Ge aufzubringen.

9. Im Infrarot bispektraler Matrixdetektor (1), aufweisend:
- eine sensible Oberfläche (3), zusammengesetzt aus einer Abfolge von Photostellen (31a), die bestimmt sind, in einem ersten Frequenzband zu empfangen, und von Photostellen (31b), die bestimmt sind, in einem zweiten Frequenzband zu empfangen, wobei der Matrixdetektors monotyp dahingehend ist, dass die Photostellen für einen selben Wellenlängenbereich sensibel sind, umfassend das erste Frequenzband und das zweite Frequenzband;
- einen Doppelband-Interferenzfilter (5), welcher die Strahlungen im ersten und zweiten Frequenzband passieren lässt, der auf der sensiblen Oberfläche (3) aufgebracht ist;
- einen ersten Interferenzfilter (4a), der auf dem Doppelband-Interferenzfilter (5) senkrecht zu den Photostellen (31a) aufgebracht ist, die bestimmt sind, im ersten Frequenzband zu empfangen;
- einen zweiten Interferenzfilter (4b), der auf dem Doppelband-Interferenzfilter (5) senkrecht zu den Photostellen (31b) aufgebracht ist, die bestimmt sind, im zweiten Frequenzband zu empfangen,
wobei einer der Interferenzfilter (4a, 4b) von dem ersten (4a) und dem zweiten (4b) Interferenzfilter ein Tiefpassfilter ist, welcher das zweite Frequenzband abschneidet, und der andere ein Hochpassfilter, welcher das erste Frequenzband abschneidet, wobei der erste Interferenzfilter (4a) und der zweite Interferenzfilter (4b) auf dem Doppelband-Interferenzfilter (5) aufgebracht sind.

## Claims

1. A method for manufacturing a bispectral array detector (1) in the infrared, including the following steps;
- (E1) providing a monotype array detector (2) including a sensitive surface (3) composed of alternating photosites (31a) intended to sense in a first frequency band and photosites (31b) intended to sense in a second frequency band, said array detector being a monotype one, in that said photosites are sensitive to the same range of wavelengths comprising the first frequency band and the second frequency band;
- (E2) depositing, on the sensitive surface (3), a dual-band interference filter (5) letting through radiation in the first and the second frequency bands;
- (E3) depositing a first interference filter (4a) above the photosites (31a) intended to sense in the first frequency band;
- (E4) depositing a second interference filter (4b) above the photosites (31b) intended to sense in the second frequency band,
one of the interference filters (4a, 4b) from the first (4a) and the second (4b) interference filters being a low-pass filter cutting the second frequency band, and the other a high-pass filter cutting the first frequency band, the first (4a) and the second (4b) interference filters being deposited on the dual-band interference filter (5).

2. The method for manufacturing a bispectral array detector (1) according to claim 1, the step (E3) of depositing a first interference filter (4a) including an etching step, the manufacturing method further including a step (E2') prior to deposition of the first filter (4a), and consisting of depositing a stopping layer (6), the thickness and the material of the stopping layer (6) being selected in such a way that the etching does not attack the dual-band interference filter (5).

3. The method for manufacturing a bispectral array detector (1) according to one of the preceding claims, the deposition (E3) of the first interference filter (4a) above the photosites (31a) intended to sense in the first frequency band including the following steps:
- (E3a) depositing the first interference filter (4a) over the entire sensitive surface (3) of the monotype array detector (2);
- (E3b) depositing a protective layer (7) on the parts of the first interference filter (4a) above the photosites (31a) intended to sense in the first frequency band;
- (E3c) etching the parts of the first interference filter (4a) not protected by the protective layer (7).

4. The method for manufacturing a bispectral array detector (1) according to the preceding claim, wherein the protective layer (7) is deposited by photolithography.

5. The method for manufacturing a bispectral array detector (1) according to one of the preceding claims, the deposition (E4) of the second interference filter (4b) above the photosites (31b) intended to sense in the second frequency band, including steps of:
- (E4a) depositing a sacrificial layer (8) above the photosites (31a) intended to sense in the first frequency band;
- (E4b) depositing the second interference filter (4b) over the entire sensitive surface (3) ;
- (E4c) removing the sacrificial layer (8).

6. The method for manufacturing a bispectral array detector (1) according to the preceding claim, the removal (E9) of the sacrificial layer being done by chemical washing.

7. The method for manufacturing a bispectral array detector (1) according to claim 5, the removal (E9) of the sacrificial layer being done by mechanical stress.

8. The method for manufacturing a bispectral array detector (1) according to one of the preceding claims, the deposition of the interference filters (4a, 4b, 5) consisting of depositing a superimposition of layers of ZnS, SiO₂ and Ge.

9. A bispectral array detector (1) in the infrared including:
- a sensitive surface (3) composed of alternating photosites (31a) intended to sense in a first frequency band and photosites (31b) intended to sense in a second frequency band, said array detector being a monotype one, in that said photosites are sensitive to the same range of wavelengths comprising the first frequency band and the second frequency band;
- a dual-band interference filter (5) letting through radiation in the first and the second frequency bands deposited on the sensitive surface (3);
- a first interference filter (4a) deposited on the dual-band interference filter (5) above the photosites (31a) intended to sense in the first frequency band;
- a second interference filter (4b) deposited on the dual-band interference filter (5) above the photosites (31b) intended to sense in the second frequency band;
one of the interference filters (4a, 4b) from the first (4a) and the second (4b) interference filters being a low-pass filter cutting the second frequency band, and the other a high-pass filter cutting the first frequency band, and the first (4a) and the second (4b) interference filters being deposited on the dual-band interference filter (5).
